# EUROPÄISCHE PATENTANMELDUNG

(11) **EP 1 309 236 A2**
(43) Veröffentlichungstag der Anmeldung: **07.05.2003**
(21) Anmeldenummer: 02024160.0
(22) Anmeldetag: 30.10.2002
(51) Int. Cl.: H05K 3/07, C25F 7/00

(54) **Verfahren zur Behandlung von elektrisch leitfähigen Substraten wie Leiterplatten und dergleichen**

(30) Priorität: 05.11.2001 DE 10154883
(71) Anmelder: Gebr. Schmid GmbH & Co., D-72250 Freudenstadt (DE)
(72) Erfinder: Zielonka, Andreas, Dr., 73525 Schwäbisch Gmünd (DE); Schmid, Christian, 72250 Freudenstadt (DE)
(74) Vertreter: Patentanwälte Ruff, Wilhelm, Beier, Dauster & Partner

(57) **Zusammenfassung**

Bei einem Verfahren zur Behandlung von elektrisch leitfähigen Substraten wie Leiterplatten, gedruckten Schaltungen und dergleichen, bei dem vorzugsweise mindestens ein Metall in einem Elektrolyten durch ein elektrisches Feld, das zwischen dem Substrat und einer vorzugsweise kathodisch geschalteten Elektrode angelegt wird, mindestens teilweise elektrochemisch abgetragen wird, sind Bereiche des Substrats, insbesondere der Substratoberfläche, zeitweise gegen das elektrische Feld abgeschirmt.

## Beschreibung

Die Erfindung betrifft ein Verfahren zur Behandlung von elektrisch leitfähigen Substraten wie Leiterplatten, gedruckten Schaltungen und dergleichen, bei dem vorzugsweise mindestens ein Metall in einem Elektrolyten durch ein elektrisches Feld, das zwischen dem Substrat und einer vorzugsweise kathodisch geschalteten Elektrode angelegt wird, mindestens teilweise elektrochemisch abgetragen wird.

Der Aufbau und die Herstellung von Leiterplatten, gedruckten Schaltungen und dergleichen sind grundsätzlich bekannt. Bei der Herstellung von solchen elektrisch leitfähigen Substraten ist es erforderlich, bereits vorhandene oder zusätzlich aufgebrachte Metallschichten abzutragen, um die entsprechenden Strukturen, z. B. Leiterbahnen, herzustellen. Das hier am häufigsten verwendete Metall ist Kupfer.

Der Metallabtrag kann grundsätzlich auf verschiedene Weise erfolgen. So ist es einerseits möglich, Methoden ohne Einsatz von flüssigen Medien zu verwenden, wie beispielsweise das lonenstrahlätzen oder das Plasmaätzen. Aus Kostengründen wird jedoch meist "naß" gearbeitet, wobei hier insbesondere das sogenannte chemische Ätzen und das sogenannte elektrochemische Ätzen zum Einsatz kommen. Im letzteren Fall wird ein Elektrolyt (z. B. Schwefelsäure) benutzt, der normalerweise keine spontane chemische Reaktion mit dem betreffenden Metall, also insbesondere dem Kupfer, eingeht. Wird jedoch ein elektrisches Feld zwischen Substrat (Leiterplatte und dergleichen) und einer meist kathodisch geschalteten Gegenelektrode angelegt, so wird das Metall durch die im Elektrolyten erzeugten lonen abgetragen.

Für das elektrochemische Ätzen müssen die elektrisch leitfähigen Substrate kontaktiert werden, um sie, meist als Anode, in den entsprechenden Stromkreis zu schalten. Dabei wird das Substrat üblicherweise an einer Seite oder an zwei gegenüberliegenden Seiten kontaktiert. Man spricht dann von der sogenannten einseitigen oder sogenannten zweiseitigen bzw. doppelseitigen Kontaktierung. Da beispielsweise die Leiterplatten kontinuierlich durch den Elektrolyten hindurchgeführt werden, wird dementsprechend einseitig oder zweiseitig parallel zur Transportrichtung, meist mit entsprechenden rollenförmigen Elementen, kontaktiert.

Wird die kontaktierte Platte in das elektrische Feld eingebracht, so erfolgt der Metallabtrag im Elektrolyten aufgrund des Eigenwiderstands des Substrats bevorzugt in der Nähe der Kontaktierung. Außerdem ist zu berücksichtigen, daß die elektrische Leitfähigkeit des Substrats selbst mindestens teilweise, meist aber hauptsächlich, durch die Metallschichten erfolgt, die durch den Behandlungsschritt teilweise abgetragen werden. Erfolgt nun dieser Abtrag bevorzugt in der Nähe der Kontaktierung, so wird die elektrische Verbindung zu den weiter entfernt liegenden Bereichen des Substrats immer schwächer und kann unter Umständen sogar vollständig abbrechen. Dies hat zur Folge, daß ein Substrat in der Nähe der Kontaktierung sauber abgetragene Strukturen aufweist, in weiter entfernten Bereichen jedoch nicht. Dies kann aus Qualitätsgründen nicht toleriert werden.

Die Erfindung stellt sich deshalb die Aufgabe, die geschilderten Nachteile zu vermeiden oder doch weitgehend auszuschließen. Insbesondere soll durch vergleichsweise einfache Maßnahmen erreicht werden, daß über das gesamte Substrat bzw. die gesamte Substratoberfläche ein möglichst gleichmäßiger Abtrag des Metalls erfolgt.

Diese Aufgabe wird gelöst durch das Verfahren mit den Merkmalen des Anspruchs 1 und durch die Vorrichtung mit den Merkmalen des Anspruchs 11. Bevorzugte Ausführungen des erfindungsgemäßen Verfahrens bzw. der erfindungsgemäßen Vorrichtung sind in den abhängigen Ansprüchen 2 bis 10 und 12 bis 15 genannt. Der Wortlaut sämtlicher Ansprüche wird hiermit durch Bezugnahme zum Inhalt dieser Beschreibung gemacht.

Das eingangs genannte Verfahren zeichnet sich erfindungsgemäß dadurch aus, daß Bereiche oder Teile des Substrats, insbesondere der Substratoberfläche während des Abtragens des Metalls zeitweise gegen das elektrische Feld abgeschirmt sind. Dies läßt sich auch so beschreiben, daß das elektrische Feld während des Abtragens die verschiedenen Bereiche des Substrats nacheinander überstreicht.

Es ist erfindungsgemäß bevorzugt, wenn das Substrat dem elektrischen Feld zu Beginn an den Stellen bzw. Bereichen ausgesetzt wird, die von der Kontaktierung entfernt sind, vorzugsweise am weitesten entfernt sind. Anschließend wird die Behandlung dann auch an Stellen oder Bereichen durchgeführt, die der Kontaktierung näherliegen, bis dann zum Schluß die der Kontaktierung nächsten Stellen oder Bereiche behandelt werden.

Bei der oben bereits erwähnten einseitigen Kontaktierung sind die am weitesten entfernten Stellen oder Bereiche diejenigen, welche auf der der Kontaktierung gegenüberliegenden Seite (der entsprechenden Substratoberfläche) liegen. Bei der oben erwähnten zweiseitigen oder doppelseitigen Kontaktierung sind die Bereiche in der Mitte des Substrats die jeweils am weitesten entfernten Stellen oder Bereiche.

In Weiterbildung ist es bei dem erfindungsgemäßen Verfahren bevorzugt, wenn Bereiche, an denen ein Abtragen des Metalls bereits stattgefunden hat, anschließend wieder vom elektrischen Feld abgeschirmt, d. h. quasi ausgeblendet werden. Dies hat den Vorteil, daß die entsprechenden Bereiche nicht unnötig lange elektrochemisch geätzt werden.

Bei dem erfindungsgemäßen Verfahren können zwei unterschiedliche bevorzugte Varianten durchgeführt werden. Zum einen kann eine, ggf. aus verschiedenen Abschirmelementen bestehende Abschirmung während des Metallabtrags über das Substrat, d. h. zum Beispiel die Leiterplatte, geführt werden. Da jedoch das Substrat üblicherweise ohnehin durch den Elektrolyten hindurchbewegt wird, ist eine Variante bevorzugt, bei der die Abschirmung fest angeordnet ist und das Substrat relativ zur Abschirmung bewegt wird. Man kann hier davon sprechen, daß bei üblichen Behandlungseinrichtungen das Substrat unter der Abschirmung hindurchbewegt wird.

Erfindungsgemäß wird das Verfahren vorzugsweise so durchgeführt, daß zum Metallabtrag bandförmige oder streifenförmige Bereiche von der Abschirmung freigelassen werden. Das Substrat läuft also unter diesem für das elektrische Feld und damit für die Behandlung offenen Bereich hindurch. Bereits behandelte Bereiche werden nach Durchlaufen des offenen Bereichs von der Behandlung wieder ausgeblendet.

Bei der geschilderten einseitigen Kontaktierung ist es bevorzugt, wenn der beschriebene, für die Behandlung offene Bereich schräg zur Transportrichtung des Substrats verläuft, vorzugsweise in einem Winkel von ca. 30° bis ca. 45°. Bei einer zweiseitigen/doppelseitigen Kontaktierung ist ein für die Behandlung offener Bereich bevorzugt, der die Form eines sich in Transportrichtung öffnenden "V" aufweist.

Desweiteren betrifft die Erfindung eine Vorrichtung zur Behandlung von elektrisch leitfähigen Substraten, die insbesondere zur Durchführung des erfindungsgemäßen Verfahrens geeignet ist. Diese Vorrichtung enthält zunächst alle üblichen Komponenten, die zur Durchführung des sogenannten elektrochemischen Ätzens erforderlich oder vorzugsweise auch zweckmäßig sind. Erfindungsgemäß zeichnet sich diese Vorrichtung dadurch aus, daß mindestens ein Abschirmelement vorgesehen ist, welches das zwischen dem Substrat und der Gegenelektrode angelegte elektrische Feld beim Metallabtrag zeitweise ausblenden kann.

Bei der erfindungsgemäßen Vorrichtung ist es bevorzugt, wenn das Abschirmelement oder die Abschirmelemente fest, d. h. ortsfest, angeordnet sind. Zweckmäßigerweise wird das Substrat bei solche Anordnungen beim Metallabtrag dann unter den Abschirmelementen durchgeführt.

In Weiterbildung ist es bevorzugt, wenn die Abschirmelemente derart angeordnet sind, daß sie auf der Substratoberfläche für den Metallabtrag band- oder streifenförmige Bereiche freilassen. Wie bereits beim erfindungsgemäßen Verfahren erwähnt, verlaufen derartige bandförmige Bereiche bei einseitiger Kontaktierung des Substrats vorzugsweise schräg zur Transportrichtung des Substrats, vorzugsweise in einem Winkel von ca. 30° bis ca. 45°. Bei zweiseitiger Kontaktierung sind vorzugsweise V-förmige bandförmige Bereiche vorgesehen, wobei das "V" sich in Transportrichtung des Substrats öffnet.

Durch das erfindungsgemäße Verfahren und die erfindungsgemäße Vorrichtung wird erreicht, daß im wesentlichen über die gesamte Substratoberfläche ein gleichmäßiger Abtrag des Metalls erfolgen kann. Die dafür notwendigen Maßnahmen lassen sich in einfacher Weise in bereits bestehende Produktionsprozesse integrieren. Die entsprechenden Maßnahmen lassen sich auch unabhängig davon durchführen, mit welcher Art oder welcher Form von Gegenelektrode gearbeitet wird.

Die beschriebenen und weitere Merkmale der Erfindung zeigen sich anhand der im folgenden beschriebenen Figuren. Dabei können die einzelnen Merkmale jeweils für sich allein oder in Kombination miteinander verwirklicht sein.

### In den Zeichnungen zeigen:

- Fig. 1a: die schematische Darstellung der Abschirmung einer Leiterplatte bei zweiseitiger Kontaktierung,
- Fig. 1b: die schematische Darstellung einer weiteren Ausführung der Abschirmung einer Leiterplatte bei zweiseitiger Kontaktierung, und
- Fig. 2: die schematische Darstellung der Abschirmung einer Leiterplatte bei einseitiger Kontaktierung.

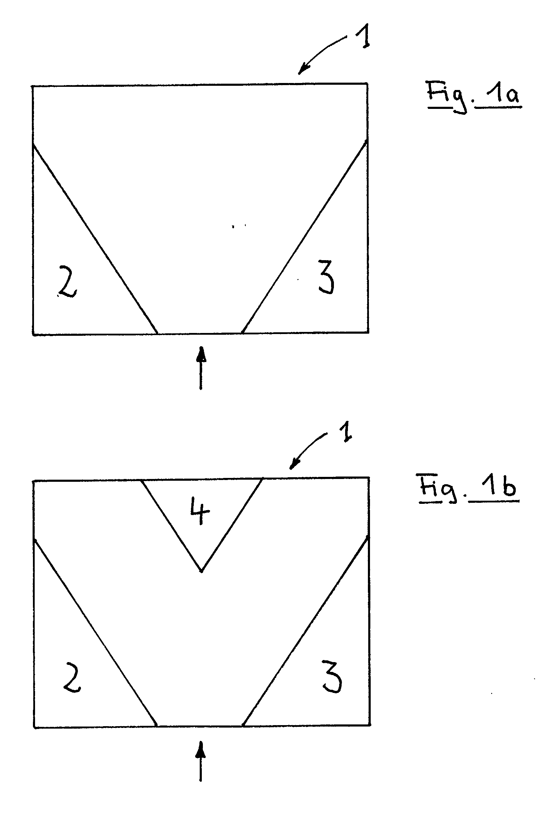

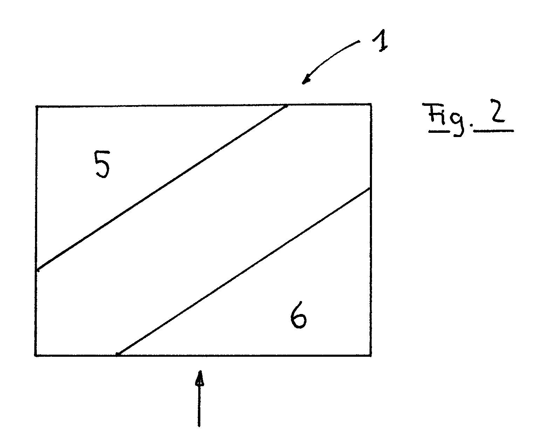

Die schematischen Darstellungen der Figuren 1a, 1b und 2 zeigen alle die Situation, bei der sich eine Leiterplatte 1 unterhalb von Abschirmelementen beim elektrochemischen Ätzen befindet. Außer dieser Leiterplatte 1 und den Abschirmelementen, deren Umrisse jeweils zeichnerisch wiedergegeben sind, sind keine weiteren Komponenten der Behandlungsvorrichtung dargestellt. Dies ist zum Verständnis der Erfindung auch nicht erforderlich. Wie bereits oben geschildert, befinden sich die Abschirmelemente üblicherweise oberhalb der durch den Behandlungsraum geführten Leiterplatte 1 und schirmen auf diese Weise das elektrische Feld ab. Die Art und Gestalt der verwendeten Gegenelektrode ist für die Erfindung nicht kritisch.

Fig. 1a zeigt die Situation bei zweiseitiger Kontaktierung der Leiterplatte 1. Die Transportrichtung der Leiterplatte 1 durch den Behandlungsraum ist durch den Pfeil angedeutet. Dementsprechend erfolgt die Kontaktierung an den beiden parallel zur Transportrichtung laufenden Seiten der Leiterplatte 1. In der Darstellung der Fig. 1a sind dies die linke und rechte Seite.
Weiter sind in Fig. 1a zwei Abschirmelemente 2 und 3 dargestellt, die jeweils Dreiecksgestalt aufweisen. Durch die Form und Anordnung der Abschirmelemente 2 und 3 wird erreicht, daß zunächst die in der Mitte liegenden Bereiche der Oberfläche der Leiterplatte 1 mit dem elektrischen Feld beaufschlagt werden. Erst zu einem späteren Zeitpunkt erfolgt auch ein Abtrag des Metalls an den linken und rechten Seiten der Leiterplatte 1, an denen die Kontaktierung erfolgt.

Wie bei allen Ausführungsformen der Erfindung können die Abschirmelemente aus einem beliebigen Material gewählt werden. Bevorzugt ist die Verwendung von Kunststoffmaterialien.

Auch Fig. 1b zeigt eine Abschirmung bei zweiseitiger Kontaktierung der Leiterplatte 1. Diesbezüglich kann auf die Beschreibung der Fig. 1a Bezug genommen werden.
Die Situation in Fig. 1b unterscheidet sich von der in Fig. 1a dadurch, daß zusätzlich zu den Abschirmelementen 2 und 3 ein weiteres Abschirmelement 4 vorgesehen ist. Dieses Abschirmelement 4 ist ebenfalls dreieckförmig und so angeordnet, daß die bei der Behandlung zuerst mit dem elektrischen Feld beaufschlagten Bereiche in der Mitte nach einer gewissen Zeit wieder "ausgeblendet" werden. Auf diese Weise wird eine zu lange Behandlungsdauer in der Mitte der Leiterplattenoberfläche verhindert. Durch die dargestellte Anordnung der Abschirmelemente 2, 3 und 4 ergibt sich auch die oben bereits beschriebene Form des für die Behandlung offenen Bereichs, nämlich das sich in Transportrichtung öffnende "V".
Der Vollständigkeit halber sei erwähnt, daß die drei Abschirmelemente 2, 3 und 4 nicht einzeln über der Leiterplatte angeordnet sein müssen, sondern sich ggf. auf einem gemeinsamen Träger oder Trägerrahmen befinden können. Die Abschirmelemente können auch Teil größerer Elemente oder Einrichtungen sein, von denen dann nur die dargestellten, hier dreieckförmigen Teile über der Leiterplatte 1 angeordnet sind. Diese Betrachtungen gelten ganz allgemein für alle Ausführungen der Erfindung.

Fig. 2 zeigt eine Ausführung, bei der die Leiterplatte 1 einseitig kontaktiert ist. Im vorliegenden Fall erfolgt die Kontaktierung an der rechten Seite der Leiterplatte 1. Diese rechte Seite verläuft parallel zu der durch den Pfeil angedeuteten Transportrichtung der Leiterplatte 1.

In Fig. 2 sind zwei dreieckförmige Abschirmelemente 5 und 6 dargestellt, die zwischen sich einen bandförmigen, schräg verlaufenden Streifen offenlassen. Innerhalb dieses Streifens ist die Leiterplattenoberfläche dem elektrischen Feld ausgesetzt, und deshalb kann hier der Metallabtrag erfolgen. Durch die gewählte Anordnung der Abschirmelemente 5 und 6 werden bereits behandelte Bereiche nach einer gewissen Zeit wieder "ausgeblendet". Außerdem ist zu erkennen, daß durch die gewählte Anordnung zunächst die der kontaktierten rechten Seite gegenüberliegende linke Seite mit dem elektrischen Feld beaufschlagt wird. Dementsprechend findet der Metallabtrag zu Beginn der Behandlung zunächst an den Stellen oder Bereichen der Leiterplattenoberfläche statt, die am weitesten von der Kontaktierung entfernt ist.

Sowohl bei einseitiger als auch bei zweiseitiger Kontaktierung kann mit der dargestellten Methode bzw. Vorrichtung ein gleichmäßiger Abtrag des Metalls über die gesamte Leiterplattenoberfläche erreicht werden.

## Patentansprüche

1. Verfahren zur Behandlung von elektrisch leitfähigen Substraten wie Leiterplatten, gedruckten Schaltungen und dergleichen, bei dem vorzugsweise mindestens ein Metall in einem Elektrolyten durch ein elektrisches Feld, das zwischen dem Substrat und einer vorzugsweise kathodisch geschalteten Elektrode angelegt wird, mindestens teilweise elektrochemisch abgetragen wird, **dadurch gekennzeichnet, daß** Bereiche des Substrats, insbesondere der Substratoberfläche, während des Abtragens zeitweise gegen das elektrische Feld abgeschirmt sind.

2. Verfahren nach Anspruch 1, **dadurch gekennzeichnet, daß** das Abtragen des Metalls in einem Bereich des Substrats beginnt, der von der Kontaktierung des Substrats für das Anlegen des elektrischen Felds entfernt, insbesondere am weitesten entfernt ist, und das Abtragen in Richtung der Kontaktierung durchgeführt wird.

3. Verfahren nach Anspruch 2, **dadurch gekennzeichnet, daß** bei Kontaktierung eines vorzugsweise rechteckförmigen Substrats an einer Seite das Abtragen an der der Kontaktierung gegenüberliegenden Seite beginnt.

4. Verfahren nach Anspruch 2, **dadurch gekennzeichnet, daß** bei Kontaktierung eines vorzugsweise rechteckförmigen Substrats an zwei gegenüberliegenden Seiten das Abtragen im Bereich der Mitte des Substrats beginnt.

5. Verfahren nach einem der vorhergehenden Ansprüche, **dadurch gekennzeichnet, daß** während des Verfahrensablaufs Bereiche des Substrats, an denen bereits ein Abtragen des Metalls stattgefunden hat, wieder gegen das elektrische Feld abgeschirmt werden.

6. Verfahren nach einem der vorhergehenden Ansprüche, **dadurch gekennzeichnet, daß** zwischen dem Substrat und der Elektrode eine Abschirmung vorgesehen ist, die während des Abtragens relativ zur Substratoberfläche bewegt wird.

7. Verfahren nach einem der Ansprüche 1 bis 5, **dadurch gekennzeichnet, daß** zwischen Substrat und Elektrode eine fest angeordnete Abschirmung vorgesehen ist, und daß während des Abtragens das Substrat relativ zur Abschirmung bewegt wird.

8. Verfahren nach Anspruch 6 oder Anspruch 7, **dadurch gekennzeichnet, daß** die Abschirmung während der Behandlung bandoder streifenförmige Bereiche auf der Substratoberfläche für das Abtragen des Metalls freiläßt.

9. Verfahren nach Anspruch 8, **dadurch gekennzeichnet, daß** bei einseitiger Kontaktierung des Substrats ein schräg zur Transportrichtung des Substrats verlaufender bandförmiger Bereich freigelassen wird.

10. Verfahren nach Anspruch 8, **dadurch gekennzeichnet, daß** bei zweiseitiger Kontaktierung des Substrats ein sich in Transportrichtung des Substrats V-förmig öffnender Bereich freigelassen wird.

11. Vorrichtung zur Behandlung von elektrisch leitfähigen Substraten wie Leiterplatten, gedruckten Schaltungen und dergleichen, insbesondere zur Durchführung des Verfahrens nach einem der vorhergehenden Ansprüche, **dadurch gekennzeichnet, daß** zwischen dem Substrat und einer vorzugsweise kathodisch geschalteten Elektrode mindestens ein Abschirmelement vorgesehen ist.

12. Vorrichtung nach Anspruch 11, **dadurch gekennzeichnet, daß** das Abschirmelement oder die Abschirmelemente fest angeordnet sind.

13. Vorrichtung nach Anspruch 11 oder Anspruch 12, **dadurch gekennzeichnet, daß** die Abschirmelemente derart angeordnet sind, daß sie auf der Substratoberfläche für das Abtragen des Metalls mindestens einen bandförmigen oder streifenförmigen Bereich freilassen.

14. Vorrichtung nach Anspruch 13, **dadurch gekennzeichnet, daß**, insbesondere bei einseitiger Kontaktierung eines vorzugsweise rechteckförmigen Substrats, die Abschirmelemente derart angeordnet sind, daß ein in Transportrichtung des Substrats schräg verlaufender bandförmiger Bereich freigelassen ist.

15. Vorrichtung nach Anspruch 14, **dadurch gekennzeichnet, daß** der bandförmige Bereich in einem Winkel von ca. 30° bis ca. 45° schräg zur Transportrichtung verläuft.

16. Vorrichtung nach Anspruch 14, **dadurch gekennzeichnet, daß**, insbesondere bei zweiseitiger Kontaktierung eines vorzugsweise rechteckförmigen Substrats, die Abschirmelemente derart angeordnet sind, daß ein in Transportrichtung sich V-förmig öffnender bandförmiger Bereich freigelassen ist.
